# FASCICULE DE BREVET EUROPEEN

(11) **EP 1 774 353 B1**
(45) Date de publication et mention de la délivrance du brevet: **05.10.2016**
(21) Numéro de dépôt: 05775266.9
(22) Date de dépôt: 06.06.2005
(51) Int. Cl.: H01M 10/42, G01R 31/36, H02J 7/00, H01M 10/44

(54) **PROCÉDÉ DE GESTION D'UN PARC DE BATTERIES RECHARGEABLES**
VERFAHREN ZUR AKKUSPEICHERVERWALTUNG
METHOD FOR MANAGING A RECHARGEABLE BATTERY STORAGE

(30) Priorité: 14.06.2004 FR 0406408
(43) Date de publication de la demande: 18.04.2007
(73) Titulaire: Commissariat à l'Énergie Atomique et aux Énergies Alternatives, 75015 Paris (FR)
(72) Inventeur: LE GALL, Murielle, F-78150 Le Chesnay (FR); BENCHETRITE, Daniel, F-94000 Creteil (FR); BACH, Olivier, F-33980 Audenge (FR)
(74) Mandataire: Hecké, Gérard
(86) Numéro de dépôt international: PCT/FR2005/001375
(87) Numéro de publication internationale: WO 2006/003287

(56) Documents cités:
- EP-A- 0 314 155
- US-A- 5 057 762
- US-A- 5 539 297
- US-A- 5 594 318
- US-A1- 2004 006 440
- US-A1- 2004 085 072
- US-B1- 6 255 801
- PATENT ABSTRACTS OF JAPAN vol. 2000, no. 01, 31 janvier 2000 (2000-01-31) -& JP 11 285159 A (TOSHIBA CORP; TOSHIBA COMPUT ENG CORP), 15 octobre 1999 (1999-10-15)
- PATENT ABSTRACTS OF JAPAN vol. 2000, no. 13, 5 février 2001 (2001-02-05) -& JP 2000 278872 A (HONDA MOTOR CO LTD), 6 octobre 2000 (2000-10-06)
- PATENT ABSTRACTS OF JAPAN vol. 1998, no. 08, 30 juin 1998 (1998-06-30) & JP 10 082843 A (MATSUSHITA ELECTRIC IND CO LTD), 31 mars 1998 (1998-03-31)

## Description

### Domaine technique de l'invention

L'invention concerne un procédé de gestion d'un parc de batteries rechargeables comportant la détermination de critères de priorité, la charge d'une batterie sélectionnée en fonction des critères de priorité et la mesure de paramètres électriques représentatifs de ladite batterie.

### État de la technique

De nombreuses installations comportent un grand nombre de batteries rechargeables. Les batteries sont généralement rechargées simultanément ou successivement de manière à les maintenir chargées en permanence.

Le brevet US 6489743 décrit un procédé de gestion d'une centrale électrique, en particulier d'une centrale comportant des batteries connectées à des panneaux solaires. Un régulateur contrôle la charge des batteries, de manière à les charger successivement au maximum, en tenant compte de leur état de charge, lorsque la source d'énergie solaire est disponible.

Le brevet US 5057762 et le document EP-A-314155 décrivent tous deux la gestion de la charge d'un ensemble de batteries rechargeables utilisant des critères de priorité basés sur l'état de charge des batteries. La priorité est donnée à la batterie la plus chargée, de manière à fournir rapidement une batterie complètement chargée.

Par ailleurs, la capacité d'une batterie diminue avec le temps, même si la batterie est complètement chargée et dans de nombreuses applications, notamment dans le domaine des télécommunications, une batterie est considérée comme défectueuse et est remplacée lorsque sa capacité est inférieure à 80% de sa capacité nominale.

Le brevet US 6255801 décrit un dispositif permettant de déterminer la capacité et/ou l'âge d'une batterie en utilisant les paramètres électriques, tension de pic et tension de plateau, représentatifs d'un effet coup de fouet pendant une décharge partielle de la batterie. Il est ainsi possible de déterminer si une batterie doit être remplacée sans la décharger complètement.

### Objet de l'invention

L'invention a pour but de fournir un procédé de gestion d'un parc de batteries ne présentant pas les inconvénients des systèmes connus et, plus particulièrement, un procédé de gestion permettant une optimisation d'un parc de batteries.

Selon l'invention, ce but est atteint par les revendications annexées et plus particulièrement par le fait que le procédé de gestion comporte l'analyse, en fonction desdits paramètres électriques, mesurés après la charge complète de la batterie sélectionnée, de l'état de santé de la batterie sélectionnée, la réactualisation des critères de priorité en fonction de l'état de santé de ladite batterie et la sélection de la batterie suivante, en fonction des critères de priorité réactualisés.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 illustre, sous forme d'organigramme, un mode de réalisation particulier d'un procédé de gestion selon l'invention.
La figure 2 représente un autre mode de réalisation particulier d'un procédé de gestion selon l'invention.
La figure 3 représente les variations de la tension aux bornes d'une batterie pleinement chargée en fonction du temps lors d'une décharge partielle, mettant en évidence l'effet coup de fouet.
La figure 4 illustre les variations de la tension aux bornes d'une batterie, respectivement après une charge complète (en trait continu) et après une charge incomplète (en traits pointillés).
La figure 5 représente schématiquement deux modes d'analyse de l'état de santé d'une batterie.
La figure 6 illustre l'évolution de la tension de pic et de plateau d'une batterie rechargeable au plomb-acide.
Les figures 7 et 8 illustrent les variations, en fonction du temps, de la tension U respectivement aux bornes de première et seconde batteries lors d'une décharge partielle.
Les figures 9 et 10 illustrent respectivement les variations de la tension U dans le cas d'une charge forcée et les variations de la tension U et du courant I dans le cas d'une charge de type courant pulsé.

### Description de modes particuliers de réalisation

Le procédé de gestion selon l'invention peut être mis en oeuvre dans un dispositif de contrôle par tout moyen approprié et, plus particulièrement au moyen d'un microprocesseur dans lequel les différentes étapes du procédé de gestion sont programmées.

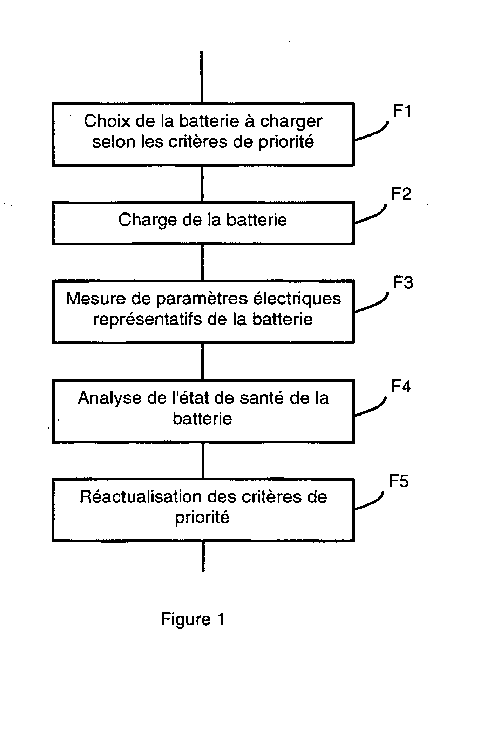

Comme représenté dans l'organigramme de la figure 1, le procédé de gestion selon l'invention comporte une étape F1 dans laquelle la batterie à charger est sélectionnée selon des critères de priorité prédéfinis. Initialement, lorsque toutes les batteries du parc sont neuves, les batteries sont chargées successivement, l'une après l'autre, dans un ordre quelconque, fixé au préalable et mis en mémoire dans le dispositif de contrôle. Ainsi, toutes les batteries sont chargées les unes après les autres avant que la première batterie chargée soit rechargée de nouveau.

La batterie à charger étant sélectionnée, elle est chargée dans une étape F2. Les paramètres de charge, associés à chaque batterie et dépendant notamment du type de batterie utilisée, peuvent être mis en mémoire au préalable dans le dispositif de contrôle et sont pris en compte automatiquement lors de la charge de la batterie sélectionnée.

Lorsque la batterie sélectionnée est complètement chargée, des paramètres électriques représentatifs de la batterie et, plus particulièrement de son état de santé, sont mesurés dans une étape F3. Ces paramètres sont ensuite analysés, dans une étape F4 pour déterminer l'état de santé de la batterie. Les critères de priorité sont ensuite réactualisés, si nécessaire, dans une étape F5 en fonction de cette analyse de l'état de santé de la batterie sélectionnée. Selon ces critères de priorité réactualisés, plus l'état de santé d'une batterie est mauvais, c'est-à-dire représentatif d'une dégradation, plus cette batterie est rechargée fréquemment. Une batterie en mauvais état sera donc rechargée plus fréquemment qu'une batterie moins dégradée, elle-même rechargée plus fréquemment qu'une batterie neuve. Après l'étape F5, une autre batterie est sélectionnée, en fonction des critères de priorité réactualisés. Cette nouvelle batterie sélectionnée est, comme précédemment, chargée avant analyse de son état de santé et, si nécessaire, nouvelle réactualisation des critères de priorité.

L'analyse de l'état de santé de chaque batterie après une recharge complète de celle-ci permet de tenir compte des différents types de dégradation susceptibles d'affecter une batterie, liés notamment à des phénomènes de sulfatation, stratification, corrosion, chute de matière active... Elle peut prendre en compte non seulement une dégradation irréversible mais également une dégradation réversible, par exemple une amélioration de l'état de santé de la batterie liée à la désulfatation d'une batterie de type électrochimique ou au plomb-acide.

Les paramètres électriques utilisés pour analyser l'état de santé d'une batterie peuvent notamment être constitués par l'impédance de la batterie, à une fréquence prédéterminée, sa conductance ou sa résistance.

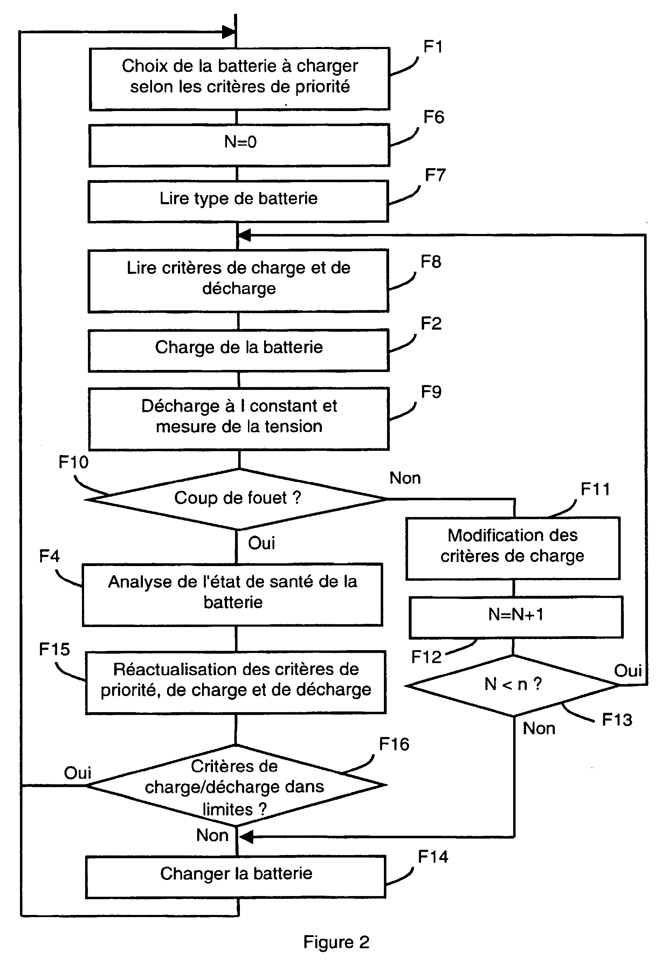

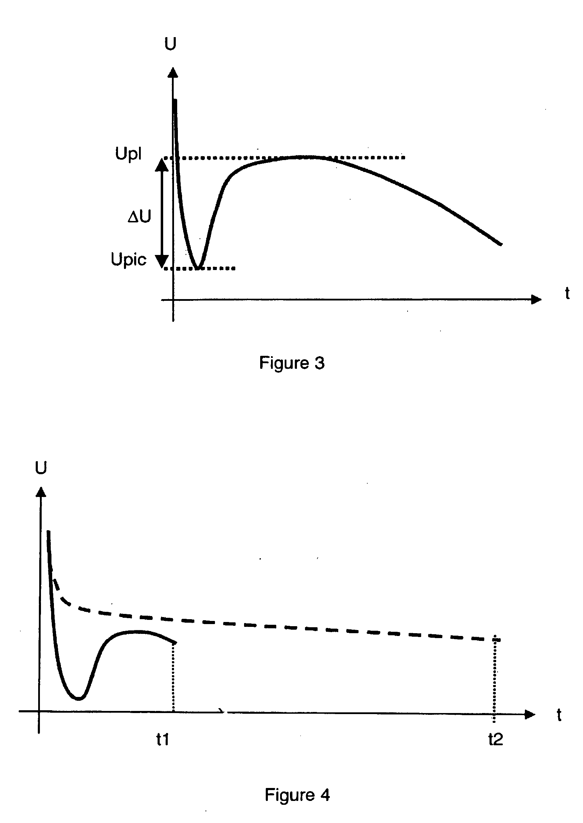

Dans un mode de réalisation préférentiel, illustré aux figures 2 et 3, l'état de santé de la batterie est analysé en utilisant la mesure de la tension aux bornes de la batterie pendant une décharge partielle, à courant constant, de la batterie chargée. L'analyse utilise plus particulièrement l'effet coup de fouet qui apparaît uniquement au début d'une décharge partielle d'une batterie complètement chargée. Les paramètres électriques utilisés sont alors la tension de pic Upic, la tension de plateau Upl ou la différence ΔU entre les valeurs de la tension de pic et de la tension de plateau atteintes par la tension aux bornes de la batterie sélectionnée, respectivement pendant des première et seconde phases de la décharge partielle.

Dans le mode de réalisation particulier de la figure 2, une grandeur N est initialement mise à zéro dans une étape F6 suivant l'étape F1. Puis, dans des étapes F7, puis F8, sont lus respectivement le type de la batterie sélectionnée et les critères de charge et de décharge correspondants, préalablement mémorisés dans le dispositif de contrôle. La charge de la batterie sélectionnée est ensuite réalisée dans l'étape F2, en tenant compte des critères de charge préalablement lus. La mesure des paramètres électriques représentatifs de la batterie et destinés à être utilisés dans l'étape F4 comporte une mesure de la tension U aux bornes de la batterie sélectionnée dans une étape F9, pendant laquelle la batterie est soumise à une décharge partielle, de préférence à courant constant. Les valeurs de tension mesurées sont ensuite analysées pendant une étape F10 pour déterminer si un effet coup de fouet a effectivement eu lieu.

Comme représenté aux figures 3 et 4 (en trait continu), l'effet coup de fouet se caractérise, de manière connue, par une chute brutale de la tension U aux bornes de la batterie dans une première phase de la décharge partielle d'une batterie complètement chargée, avant une remontée de la tension jusqu'à un plateau pendant une seconde phase. Pendant l'étape F10, sont ainsi déterminées la tension de pic Upic, correspondant à la valeur minimum de la tension U pendant la décharge partielle, et la tension de plateau Upl, correspondant à la valeur maximum atteinte par la tension U après sa remontée.

La décharge et, en conséquence, la mesure de la tension peut être interrompue dès que l'effet coup de fouet apparaît, c'est-à-dire à un instant t1 (courbe en trait continu de la figure 4) auquel la tension diminue de nouveau après une augmentation de tension. En général, ce phénomène apparaît très rapidement lorsque la batterie est complètement chargée, ce qui permet de réduire au minimum le temps de décharge. Celui-ci peut, à titre d'exemple, être limité à quelques minutes. Par ailleurs, la décharge est automatiquement interrompue à un instant t2, après une durée prédéterminée, pour ne pas pénaliser l'utilisateur si la batterie n'a pas été complètement chargée (courbe en traits pointillés de la figure 4) pendant l'étape F2.

Si l'effet coup de fouet est constaté (sortie Oui de F10), l'analyse de l'état de santé de la batterie est réalisée dans l'étape F4, en tenant compte des valeurs de la tension de pic Upic et/ou de la tension de plateau Upl et/ou de la différence ΔU entre ces deux valeurs (ΔU=Upl-Upic).

En l'absence d'effet coup de fouet à l'instant t2, correspondant à une charge incomplète de la batterie (sortie Non de F10), il est possible de modifier les critères de charge, dans une étape F11, avant de revenir à l'étape F8 pour compléter la charge de la batterie. Dans le mode particulier de réalisation illustré à la figure 2, la grandeur N est alors incrémentée (N=N+1) dans une étape F12 suivant l'étape F11, puis la nouvelle valeur de la grandeur N est comparée à un seuil prédéterminé n dans une étape F13. Si la grandeur N est inférieure au seuil n (sortie Oui de F13), le dispositif de contrôle se reboucle sur l'étape F8 pour compléter la charge de la batterie. Dans le cas contraire (sortie Non de F13), c'est-à-dire si la batterie n'est toujours pas complètement chargée après n tentatives, la batterie est considérée comme défectueuse et l'utilisateur est prévenu, dans une étape F14, que cette batterie doit être remplacée ("changer la batterie").

L'étape F4 d'analyse de l'état de santé de la batterie est suivie d'une étape F15, qui comme l'étape F5 de la figure 1, comporte la réactualisation des critères de priorité, si nécessaire, en fonction de l'état de santé de la batterie. Simultanément, les critères de charge et de décharge peuvent également être réactualisés en fonction de l'état de santé de la batterie. Les critères de charge et de décharge réactualisés sont ensuite, dans une étape F16, comparés à des limites prédéterminées associées au type de batterie utilisé et à l'application qui en est faite. Si les critères de charge et de décharge réactualisés restent dans ces limites (sortie Oui de F16), le dispositif de contrôle se reboucle sur l'étape F1 et sélectionne une autre batterie, en fonction des critères de priorité réactualisés. Cette nouvelle batterie sélectionnée est, comme précédemment, chargée avant analyse de son état de santé et, si nécessaire, nouvelle réactualisation des critères de priorité.

Si les critères de charge et de décharge sont en dehors des limites (sortie Non de F16), la batterie est considérée comme défectueuse et le dispositif de contrôle passe à l'étape F14, prévenant l'utilisateur que la batterie est à remplacer avant de se reboucler sur l'étape F1.

L'analyse de l'état de santé de la batterie (étape F4) peut être effectuée en comparant les valeurs mesurées après la charge complète de la batterie, pendant les étapes F3 ou F9, des paramètres électriques (impédance, conductance, résistance, Upic, Uplateau ou ΔU) à des seuils prédéterminés ou en analysant leur évolution.

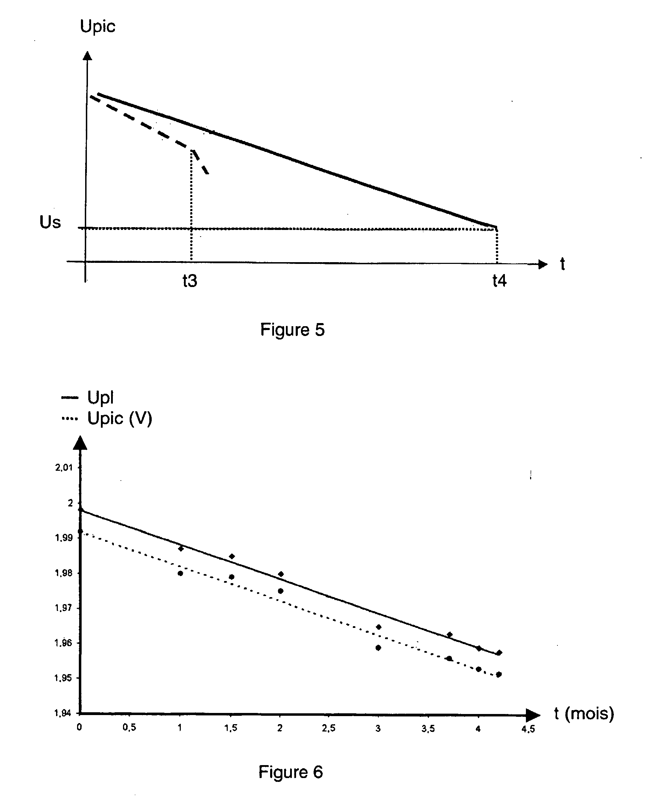

À titre d'exemple, comme représenté par la courbe en trait plein de la figure 5, dans un premier mode d'analyse de l'état de santé d'une batterie, la tension de pic Upic est comparée à un seuil Us. Une dégradation de l'état de santé de la batterie imposant une réactualisation des critères de priorité et, éventuellement, de charge et de décharge est détectée lorsque, à l'instant t4, la tension de pic descend au-dessous du seuil Us.

Selon un autre mode d'analyse, représenté par la courbe en traits pointillés de la figure 5, l'évolution temporelle de la tension de pic Upic est analysée. Bien que la valeur de la tension pic soit supérieure au seuil Us, la présence d'une rupture de pente, à l'instant t3, est considérée comme représentative d'une détérioration de l'état de santé de la batterie, nécessitant une réactualisation des critères de priorité et, éventuellement, de charge et de décharge.

À titre d'exemple, la figure 6 illustre, respectivement en traits pointillés et en traits pleins, l'évolution dans le temps, sur une période de 4 mois d'utilisation, de la tension de pic Upic et de la tension de plateau Upl d'une première batterie rechargeable au plomb-acide. Cette batterie, constituée par une cellule électrochimique ouverte à électrolyte liquide a une capacité initiale de 25Ah. Elle est utilisée avec des seuils de tension de 1,75V en décharge et de 2,3V en charge, avec des courants de charge et de décharge de 2,5A, pour une durée de charge ou de décharge de 10 heures.

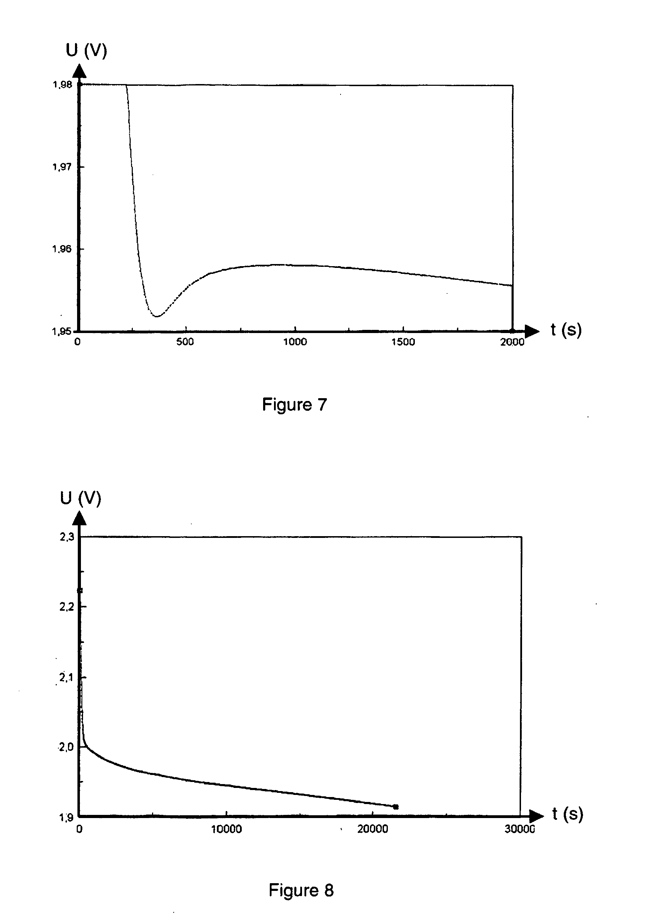

La figure 7 illustre l'effet coup de fouet mesuré dans une étape F9 et constaté dans une étape F10 (figure 2) après 4,2 mois de fonctionnement de cette première batterie, soit au 128^{ème} jour de fonctionnement. La comparaison (analyse de l'étape F4) de la tension pic Upic alors obtenue à la courbe de tension pic préalablement mesurée et enregistrée, illustrée sur la figure 6, montre qu'il n'y a pas de rupture dans l'évolution de la tension pic. De plus, la tension pic mesurée reste supérieure au seuil Us, qui est par exemple de 1,91V par cellule (soit 11,46V pour une batterie constituée de 6 cellules). Les critères de priorité, de charge et de décharge ne sont donc pas réactualisés à l'étape F15.

La mesure après 5 mois de fonctionnement, pendant une étape F9, de la tension U aux bornes d'une seconde batterie, est illustrée à la figure 8. Il s'agit d'une cellule électrochimique au plomb-acide, d'une capacité initiale de 25Ah. Elle est utilisée avec des seuils de tension de 1,75V en décharge et de 2,4V en charge, avec des courants de charge et de décharge de 2,3A, pour une durée de charge ou de décharge de 10 heures. L'absence de phénomène coup de fouet (sortie Non de F10) conduit à la modification des critères de charge et de décharge (étape F11). À titre d'exemple, le seuil de tension de charge est alors augmenté et fixé à 2,45V et la charge est modifiée pour être du type charge forcée ("boost charge" en anglais) pour compléter la charge de cette batterie (rebouclage sur l'étape F8).

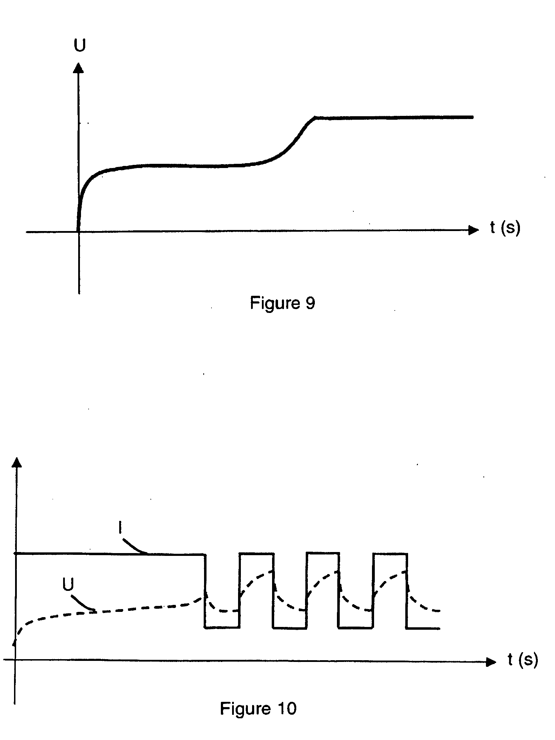

De manière générale, tous les types de charge ou de décharge peuvent être utilisés, en tenant compte du type de batterie et du type d'application dans laquelle cette batterie est utilisée. De manière connue, la tension aux bornes de la batterie et/ou le courant de charge et de décharge sont contrôlés et/ou mesurés pendant la charge ou la décharge. Les critères de charge et de décharge peuvent être constitués par des profils temporels de tension et de courant, par des valeurs de courant de charge et de décharge, par des seuils de tension de charge et de décharge, par des coefficients de surcharge à appliquer en fin de charge. Différents types de charge peuvent également être utilisés, éventuellement avec une modification en cours de charge. À titre d'exemple, la figure 9 illustre les variations de la tension U dans le cas d'une charge de type forcée, avec une charge jusqu'à une tension de seuil, qui peut, par exemple, être de 2,45V par cellule, suivie d'une charge à tension constante (par exemple de 2,45V par cellule). Les variations du courant I et de la tension U dans le cas d'une charge de type courant pulsé à haute fréquence sont illustrées à la figure 10, respectivement en trait plein et en traits pointillés.

La recharge de la batterie sélectionnée (étape F2) peut être réalisée en utilisant le courant disponible dans l'installation comportant le parc de batteries. Il peut s'agir notamment d'énergie solaire dans des installations photovoltaïque ou d'énergie fournie par un générateur diesel dans des installations hybrides. Dans le cas où l'énergie extérieure au parc de batteries n'est pas disponible, notamment si la recharge est effectuée de nuit dans une installation photovoltaïque, la batterie sélectionnée peut être rechargée à partir des autres batteries du parc. Cette dernière méthode est intéressante dans la mesure où les pertes d'énergie entre batteries sont négligeables ou de faible importance. Dans le cas de batteries au plomb-acide notamment, la recharge par les autres batteries d'une batterie sélectionnée ne provoque qu'une faible perte d'énergie en fin de charge, du fait du phénomène de dégazage.

De plus, lors des décharges partielles pour la mesure de l'état de santé des batteries, l'énergie fournie par la batterie testée peut être directement distribuée aux autres batteries non entièrement chargées, afin de ne pas pénaliser l'utilisateur par ce système de gestion.

Le terme batterie utilisé dans la description ci-dessus englobe aussi bien les batteries que les cellules électrochimiques.

Alors que, dans l'art antérieur, les critères de priorité sont basés sur l'état de charge des batteries, sans tenir compte de leur état de santé, selon l'invention, c'est donc l'état de santé des batteries qui est pris en compte. Ces caractéristiques ne sont pas analogues. En effet, une batterie totalement chargée peut être aussi bien en bonne santé qu'en mauvaise santé. Il en va de même d'une batterie totalement déchargée. Dans l'art antérieur, la batterie chargée en priorité est la batterie la plus chargée, de manière à fournir rapidement une batterie complètement chargée, tandis que l'invention permet de charger en priorité la batterie la pus dégradée et ainsi de recharger plus souvent les batteries en mauvais état.

Le procédé de gestion selon l'invention permet donc d'assurer une gestion intelligente d'un parc de batteries ou d'un ensemble de cellules électrochimiques, tenant compte de leur état de santé et de son évolution au cours du temps. L'état de santé du parc peut être contrôlé en permanence et la gestion du parc peut être continue ou ponctuelle, notamment dans le cadre d'une opération de réhabilitation d'un parc de batteries.

## Revendications

1. Procédé de gestion d'un parc de batteries rechargeables comportant :
• la sélection d'une batterie en fonction de critères de priorité initiaux prédéfinis,
• la charge (F2) de la batterie sélectionnée (F1),
• la mesure (F3) de paramètres électriques représentatifs de ladite batterie sélectionnée,
procédé **caractérisé en ce qu'**il comporte :
• l'analyse (F4) de l'état de santé de la batterie sélectionnée, par comparaison desdits paramètres électriques mesurés après la charge de ladite batterie à des seuils prédéterminés ou par détection d'une rupture dans l'évolution desdits paramètres électriques mesurés pendant une durée prédéterminée, après la charge complète de ladite batterie sélectionnée,
• l'actualisation (F5) des critères de priorité en fonction de l'analyse de l'état de santé de ladite batterie, et
• la sélection de la batterie suivante, en fonction des critères de priorité actualisés.

2. Procédé selon la revendication 1, **caractérisé en ce que** la mesure des paramètres électriques de la batterie sélectionnée comporte la mesure de l'impédance de ladite batterie.

3. Procédé selon la revendication 1, **caractérisé en ce que** la mesure des paramètres électriques de la batterie sélectionnée comporte la mesure de la conductance de ladite batterie.

4. Procédé selon la revendication 1, **caractérisé en ce que** la mesure des paramètres électriques de la batterie sélectionnée comporte la mesure de la résistance de ladite batterie.

5. Procédé selon la revendication 1, **caractérisé en ce que** la mesure des paramètres électriques de la batterie sélectionnée comporte la mesure de la tension (U) aux bornes de ladite batterie pendant une décharge partielle à courant (I) constant (F9).

6. Procédé selon la revendication 5, **caractérisé en ce que** la mesure des paramètres électriques comporte la mesure de paramètres représentatifs d'un effet coup de fouet pendant la décharge partielle.

7. Procédé selon la revendication 6, **caractérisé en ce que** la mesure de paramètres représentatifs d'un effet coup de fouet comporte la détermination d'une tension de pic (Upic), pendant la décharge partielle.

8. Procédé selon la revendication 6, **caractérisé en ce que** la mesure des paramètres représentatifs d'un effet coup de fouet comporte la détermination d'une tension de plateau (Upl) pendant la décharge partielle.

9. Procédé selon la revendication 6, **caractérisé en ce que** la mesure des paramètres représentatifs d'un effet coup de fouet comporte la détermination de la différence (ΔU) entre les valeurs d'une tension de pic (Upic) et d'une tension de plateau (Upl) atteintes par la tension de la batterie sélectionnée respectivement pendant des première et seconde phases de la décharge partielle.

10. Procédé selon l'une quelconque des revendications 6 à 9, **caractérisé en ce qu'**il comporte la modification (F11) des critères de charge de la batterie sélectionnée en l'absence d'effet coup de fouet pendant la décharge partielle.

## Patentansprüche

1. Verfahren zur Verwaltung einer Gruppe von wiederaufladbaren Batterien, umfassend:
• das Auswählen einer Batterie in Abhängigkeit von vordefinierten Ausgangsprioritätskriterien,
• das Laden (F2) der ausgewählten Batterie (F1),
• das Messen (F3) von für die ausgewählte Batterie repräsentativen elektrischen Parametern,
Verfahren, **dadurch gekennzeichnet, dass** es umfasst:
• das Analysieren (F4) des Gesundheitszustandes der ausgewählten Batterie durch Vergleichen der nach dem Laden der Batterie gemessenen elektrischen Parameter mit vorbestimmten Schwellwerten oder durch Erfassen eines Bruchs in der Entwicklung der gemessenen elektrischen Parameter während einer vorbestimmten Dauer, nach dem vollständigen Laden der ausgewählten Batterie,
• das Aktualisieren (F5) der Prioritätskriterien in Abhängigkeit von der Analyse des Gesundheitszustandes der Batterie, und
• das Auswählen der nächsten Batterie in Abhängigkeit von den aktualisierten Prioritätskriterien.

2. Verfahren nach Anspruch 1, **dadurch gekennzeichnet, dass** die Messung der elektrischen Parameter der ausgewählten Batterie die Messung der Impedanz der Batterie umfasst.

3. Verfahren nach Anspruch 1, **dadurch gekennzeichnet, dass** die Messung der elektrischen Parameter der ausgewählten Batterie die Messung des Leitwertes der Batterie umfasst.

4. Verfahren nach Anspruch 1, **dadurch gekennzeichnet, dass** die Messung der elektrischen Parameter der ausgewählten Batterie die Messung des Widerstands der Batterie umfasst.

5. Verfahren nach Anspruch 1, **dadurch gekennzeichnet, dass** die Messung der elektrischen Parameter der ausgewählten Batterie die Messung der Spannung (U) an den Anschlüssen der Batterie während einer Teilentladung bei konstantem Strom (I) (F9) umfasst.

6. Verfahren nach Anspruch 5, **dadurch gekennzeichnet, dass** die Messung der elektrischen Parameter die Messung von Parametern, die für einen Spannungssack-Effekt während der Teilentladung repräsentativ sind, umfasst.

7. Verfahren nach Anspruch 6, **dadurch gekennzeichnet, dass** die Messung von Parametern, die für einen Spannungssack-Effekt repräsentativ sind, das Bestimmen einer Peak-Spannung (Upic) während der Teilentladung umfasst.

8. Verfahren nach Anspruch 6, **dadurch gekennzeichnet, dass** die Messung der Parameter, die für einen Spannungssack-Effekt repräsentativ sind, das Bestimmen einer Plateau-Spannung (Upl) während der Teilentladung umfasst.

9. Verfahren nach Anspruch 6, **dadurch gekennzeichnet, dass** die Messung der Parameter, die für einen Spannungssack-Effekt repräsentativ sind, das Bestimmen der Differenz (ΔU) zwischen den Werten einer Peak-Spannung (Upic) und einer Plateau-Spannung (Upl), die durch die Spannung der ausgewählten Batterie während einer ersten bzw. einer zweiten Phase der Teilentladung erreicht werden, umfasst.

10. Verfahren nach einem der Ansprüche 6 bis 9, **dadurch gekennzeichnet, dass** es die Änderung (F11) der Ladekriterien der ausgewählten Batterie bei Nichtvorliegen eines Spannungssack-Effekts während der Teilentladung umfasst.

## Claims

1. Method for managing a pool of rechargeable batteries comprising:
• selecting (F1) a battery according to predefined initial priority criteria,
• charging (F2) said selected battery (F1),
• measuring (F3) electrical parameters representative of said selected battery,
method **characterized in that** it comprises:
• analysing (F4) the state of health of the selected battery, by comparison of said electrical parameters measured after said battery has been charged with preset thresholds, or by detecting a break in the evolution of said electrical parameters measured during a preset period after the battery has been charged.
• updating (F5) the priority criteria according to the analysis of the state of health of said battery,
• selecting the next battery according to the updated priority criteria.

2. Method according to claim 1, **characterized in that** the measurement of the electrical parameters of the selected battery comprises measurement of the impedance of said battery.

3. Method according to any claim 1, **characterized in that** the measurement of the electrical parameters of the selected battery comprises measurement of the conductance of said battery.

4. Method according to claim 1, **characterized in that** the measurement of the electrical parameters of the selected battery comprises measurement of the resistance of said battery.

5. Method according to claim 1, **characterized in that** the measurement of the electrical parameters of the selected battery comprises measurement of the voltage (U) at the terminals of said battery during a partial discharge (F9) at constant current (I).

6. Method according to claim 5, **characterized in that** the measurement of the electrical parameters comprises measurement of parameters representative of a coup de fouet effect during the partial discharge.

7. Method according to claim 6, **characterized in that** the measurement of parameters representative of a coup de fouet effect comprises determination of a peak voltage (Upeak) during the partial discharge.

8. Method according to claim 6, **characterized in that** the measurement of parameters representative of a coup de fouet effect comprises determination of a plateau voltage (Upl) during the partial discharge.

9. Method according to claim 6, **characterized in that** the measurement of parameters representative of a coup de fouet effect comprises determination of the difference (ΔU) between the values of a peak voltage (Upeak) and of a plateau voltage (Upl) reached by the voltage of the selected battery respectively during first and second phases of the partial discharge.

10. Method according to any of claims 6 to 9, **characterized in that** it comprises modification (F11) of the charging criteria of the selected battery in the absence of coup de fouet effect during the partial discharge.
